# EUROPEAN PATENT APPLICATION

(11) **EP 4 793 933 A1**
(43) Date of publication of application: **19.08.2026**
(21) Application number: 25846206.8
(22) Date of filing: 29.08.2025
(51) Int. Cl.: G09G 3/3225, G09G 3/20, G11C 19/28

(54) **DISPLAY PANEL AND DISPLAY APPARATUS**

(30) Priority: 30.12.2024 CN 202411969111
(71) Applicant: Xiamen Tianma Display Technology Co., Ltd., Xiamen, Fujian 361101 (CN)
(72) Inventor: LIN, Lizi, Fujian 361101 (CN); GAO, Yana, Fujian 361101 (CN); ZHOU, Xingyao, Fujian 361101 (CN); XIA, Zhiqiang, Fujian 361101 (CN); YANG, Kang, Fujian 361101 (CN)
(74) Representative: Germain Maureau
(86) International application number: PCT/CN2025/117688
(87) International publication number: WO 2026/144217

(57) **Abstract**

A display panel and a display apparatus are provided according to embodiment of the present disclosure. The display panel includes cascade shift register units. The shift register unit includes an input module, a stage transmission module, an output module, and a control module. The stage transmission module includes a first control terminal and is configured to output a low-level signal based on a signal from the first control terminal and a first clock signal. The output module includes a second control terminal and is configured to output a high-level signal based on a signal from the second control terminal and a second clock signal. The first clock signal and the second clock signal have opposite phases. A control terminal of the control module and an output terminal of the input module are connected to a first node, one of the first control terminal and the second control terminal is connected to an output terminal of the control module, and the other is connected to the first node. According to the present disclosure, the mutual influence between the first clock signal and the second clock signal can be isolated, and the stage transmission module can output a stable waveform, thereby improving the performance reliability of the shift driving circuit.

## Description

The present application claims priority to Chinese patent application No. 202411969111.3, filed on December 30, 2024, and titled "DISPLAY PANEL AND DISPLAY APPARATUS", the content of which is incorporated herein by reference in its entirety.

### TECHNICAL FIELD

The present disclosure relates to the technical field of displaying and, in particular, to a display panel and a display apparatus.

### BACKGROUND

Indium gallium zinc oxide (IGZO) is a material used for the channel layer in the new-generation thin-film transistor technology, and is part of the metal oxide panel technology. IGZO transistors have the advantages of high mobility and low leakage current, which can better improve display persistence and reduce costs. At present, pixel circuits entirely made of metal oxide transistors have become one of the technological development trends. Therefore, providing a shift driving circuit suitable for such pixel circuits is a technical problem that needs to be urgently addressed.

### SUMMARY

To address the problems in the prior art, the present disclosure provides a display panel and a display apparatus, so as to provide a shift driving circuit that outputs high-level scan signals with high performance reliability, thereby improving product yield.

In a first aspect, an embodiment of the present disclosure provides a display panel, including a plurality of shift register units in a cascade configuration. At least one of the shift register units includes an input module, a stage transmission module, an output module, and a control module. An output terminal of the stage transmission module in an i-th stage shift register unit is connected to an input terminal of the input module in an (i+1)-th stage shift register unit, where i is a positive integer. The stage transmission module includes a first control terminal, and is configured to output a low-level signal based on a signal from the first control terminal and a first clock signal. The output module includes a second control terminal, and is configured to output a high-level signal based on a signal from the second control terminal and a second clock signal. The first clock signal and the second clock signal have opposite phases. A control terminal of the control module and an output terminal of the input module are connected to a first node, one of the first control terminal and the second control terminal is connected to an output terminal of the control module, and the other of the first control terminal and the second control terminal is connected to the first node.

In a second aspect, based on the same inventive concept, an embodiment of the present disclosure further provides a display apparatus, including the display panel according to any one of the embodiments of the present disclosure.

The display panel and display apparatus according to the embodiments of the present disclosure have the following advantages: the shift register unit includes the stage transmission module, the output module, and the control module. The signal output by the stage transmission module is transmitted to the next-stage shift register unit to achieve cascading, and the signal output by the output module serves as the scan signal. One control terminal of the control module is connected to the first node, one of the first control terminal of the stage transmission module and the second control terminal of the output module is connected to the first node, and the other is connected to the output terminal of the control module, so that the first control terminal and the second control terminal are controlled by their respective signal lines. In this way, the mutual influence between the first clock signal received by the stage transmission module and the second clock signal received by the output module can be isolated, the signal transition of the second clock signal will not affect the waveform of the signal from the output terminal of the stage transmission module, thereby improving the performance reliability of the shift driving circuit and the yield of the display panel product.

### BRIEF DESCRIPTION OF DRAWINGS

In order to clearly illustrate the technical solutions of embodiments of the present disclosure or of the prior art, a brief description will be given below of the drawings required for describing the embodiments or the prior art. It is apparent that the drawings in the following description show only some embodiments of the present disclosure, and those skilled in the art can derive other drawings based on these drawings without any creative effort.
FIG. 1 is a schematic diagram of a pixel circuit in the related art;
FIG. 2 is a schematic diagram of a shift register unit in the related art;
FIG. 3 is a timing diagram in the related art;
FIG. 4 is a schematic diagram of a display panel according to an embodiment of the present disclosure;
FIG. 5 is a schematic diagram of a shift register unit according to an embodiment of the present disclosure;
FIG. 6 is a schematic diagram of a further shift register unit according to an embodiment of the present disclosure;
FIG. 7 is a schematic diagram of a cascade configuration of shift register units according to an embodiment of the present disclosure;
FIG. 8 is a timing diagram according to an embodiment of the present disclosure;
FIG. 9 is a schematic diagram of a further shift register unit according to an embodiment of the present disclosure;
FIG. 10 is a schematic diagram of a further shift register unit according to an embodiment of the present disclosure;
FIG. 11 is a schematic diagram of a further shift register unit according to an embodiment of the present disclosure;
FIG. 12 is a schematic diagram of a further shift register unit according to an embodiment of the present disclosure;
FIG. 13 is a schematic diagram of a further shift register unit according to an embodiment of the present disclosure;
FIG. 14 is a further timing diagram according to an embodiment of the present disclosure;
FIG. 15 is a schematic diagram of a further shift register unit according to an embodiment of the present disclosure;
FIG. 16 is a schematic diagram of a further shift register unit according to an embodiment of the present disclosure;
FIG. 17 is a further timing diagram according to an embodiment of the present disclosure;
FIG. 18 is a schematic diagram of a further shift register unit according to an embodiment of the present disclosure;
FIG. 19 is a schematic diagram of a further shift register unit according to an embodiment of the present disclosure; and
FIG. 20 is a schematic diagram of a display apparatus according to an embodiment of the present disclosure.

### DESCRIPTION OF EMBODIMENTS

In order to clearly illustrate the objectives, technical solutions, and advantages of embodiments of the present disclosure, the technical solutions of the embodiments of the present disclosure will be clearly and completely described below in conjunction with the drawings of the embodiments of the present disclosure. It is apparent that the described embodiments are part, rather than all, of the embodiments of the present disclosure. All other embodiments derived by those skilled in the art based on the embodiments of the present disclosure without any creative effort fall within the protection scope of the present disclosure.

It will be apparent to those skilled in the art that various modifications and variations can be made to the present disclosure without departing from the spirit or scope of the present disclosure. Therefore, the present disclosure is intended to cover modifications and variations of the present disclosure that fall within the scope of the attached claims (technical solutions claimed for protection) and their equivalents. It should be noted that the implementations provided by the embodiments of the present disclosure may be combined with each other unless there is any inconsistency.

The terms used in the embodiments of the present disclosure are only for the purpose of describing specific embodiments and are not intended to limit the present disclosure. The singular forms "a/an", "said" and "the" used in the embodiments of the present disclosure and the attached claims are also intended to include plural forms unless the context clearly indicates otherwise.

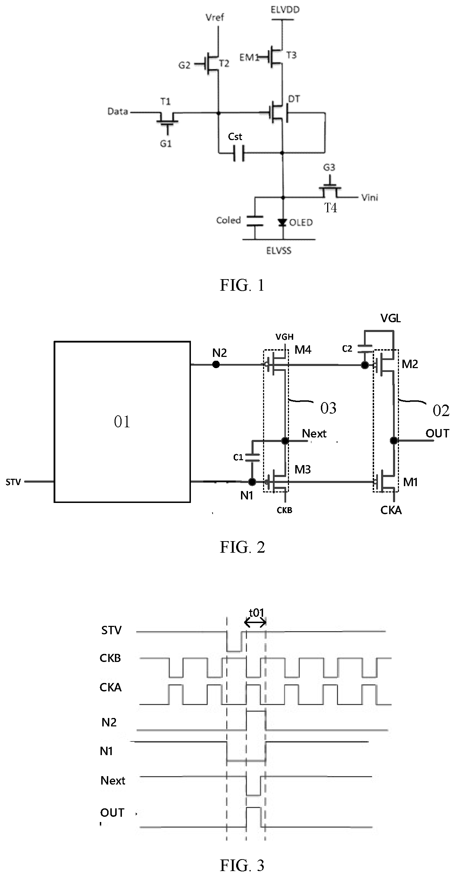

FIG. 1 is a schematic diagram of a pixel circuit in the related art. As shown in FIG. 1, the pixel circuit includes a driving transistor DT, a data writing transistor T1, a gate reset transistor T2, a light-emitting control transistor T3, an electrode reset transistor T4, and a storage capacitor Cst. The driving transistor DT has a dual-gate structure, including a top gate and a bottom gate. The top gate is connected to the data writing transistor T1, the gate reset transistor T2, and a plate of the storage capacitor Cst. The bottom gate is connected to the other plate of the storage capacitor Cst. The operation of the pixel circuit also requires a first power supply signal ELVDD, a reset signal Vref, a constant voltage signal Vini, a data signal Data, a light-emitting control signal EM1, a scan signal G1, a scan signal G2, and a scan signal G3. The pixel circuit is connected to a first electrode of a light-emitting device OLED (Organic Light-Emitting Diode), and a second electrode of the light-emitting device OLED is connected to a second power supply signal ELVSS. Coled represents a parasitic capacitance of the OLED device itself. An active layer of each transistor in the pixel circuit includes a metal oxide, and the transistor is an n-type transistor. The enable levels of the control signals required by the pixel circuit, such as the light-emitting control signal EM1, the scan signal G1, the scan signal G2, and the scan signal G3, are high. Therefore, a shift register unit capable of providing a high-level enable level is required.

FIG. 2 is a schematic diagram of a shift register unit in the related art. As shown in FIG. 2, the shift register unit includes an input module 01, an output module 02, and a stage transmission module 03. The output module 02 includes a first output transistor M1 and a second output transistor M2. The stage transmission module 03 includes a third output transistor M3 and a fourth output transistor M4. Each output transistor is a p-type transistor. The input module 01 writes signals to a node N1 and a node N2, respectively, based at least on an input signal STV. Control terminals of the first output transistor M1 and the third output transistor M3 are connected to the node N1, and control terminals of the second output transistor M2 and the fourth output transistor M4 are connected to the node N2. A capacitor C1 and a capacitor C1 are further provided in the shift register unit. A first terminal of the first output transistor M1 receives a clock signal CKA, and a second terminal of the first output transistor M1 is connected to an output terminal OUT of the output module 02. A first terminal of the second output transistor M2 receives a low-level signal VGL, and a second terminal of the second output transistor M2 is connected to the output terminal OUT of the output module 02. A first terminal of the third output transistor M3 receives a clock signal CKB, and a second terminal of the third output transistor M3 is connected to an output terminal Next of the stage transmission module 03. A first terminal of the fourth output transistor M4 receives a high-level signal VGH, and a second terminal of the fourth output transistor M4 is connected to the output terminal Next of the stage transmission module 03.

FIG. 3 is a timing diagram in the related art that can be used to drive the shift register unit according to the embodiment of FIG. 2. With reference to FIG. 3, during a period t01, the node N2 is at a high potential and the node N1 is at a low potential. The first output transistor M1 is turned on, and the output terminal OUT of the output module 02 outputs a high-level signal provided by the clock signal CKA. The third output transistor M3 is turned on, and the output terminal Next of the stage transmission module 03 outputs a low-level signal provided by the clock signal CKB. Since the control terminals of the first output transistor M1 and the third output transistor M3 are both connected to the node N1, the clock signal CKA and the clock signal CKB have opposite phases. During the period t01, the clock signal CKA transitions from a low level to a high level, and the clock signal CKB transitions from a high level to a low level. These two signals affect the potential of the node N1 through parasitic capacitance, thereby causing mutual influence between the output waveforms. Moreover, since the signal output by the first output transistor M1 serves as the scan signal, the parasitic capacitance between the gate and the source of the first output transistor M1 is relatively large, and the voltage transition of the clock signal CKA pull the node N1 high to a great extent, thereby resulting in an abnormal waveform of the cascade output, and affecting the performance reliability of the shift driving circuit.

To solve the problems existing in the related art, an embodiment of the present disclosure provides a display panel, in which an additional control signal is added to the shift register, so that the first control terminal of the stage transmission module and the second control terminal of the output module are respectively controlled by their respective signals. In this way, the mutual influence between the clock signal received by the stage transmission module and the clock signal received by the output module is isolated, thereby improving the performance reliability of the shift driving circuit.

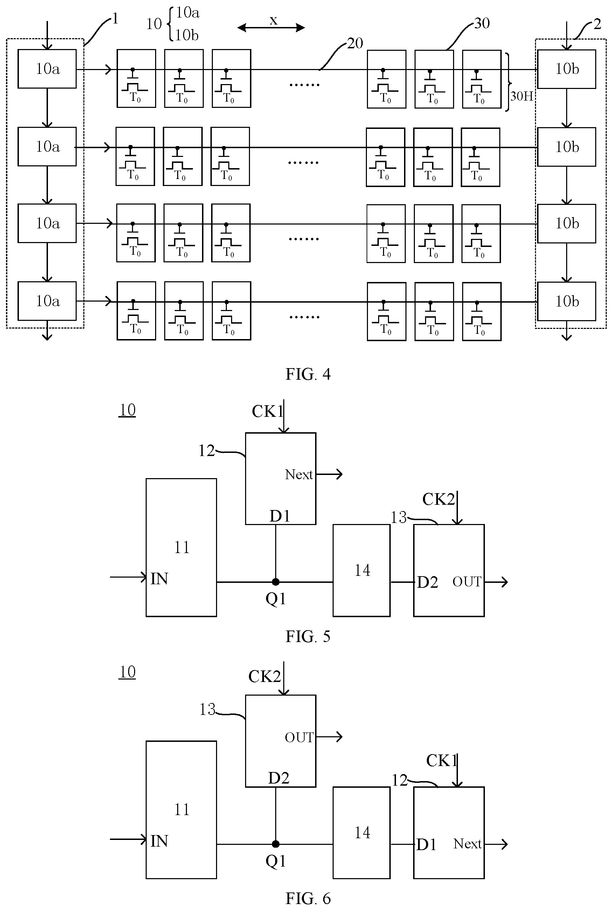

FIG. 4 is a schematic diagram of a display panel according to an embodiment of the present disclosure. As shown in FIG. 4, the display panel includes a plurality of shift register units 10, a plurality of scan lines 20, and a plurality of pixel circuits 30. The pixel circuit 30 includes a first functional transistor T₀, and the first functional transistor T₀ is an n-type transistor. At least one transistor in the pixel circuit 30 is an n-type transistor. In some embodiments of the present disclosure, the specific structure of the pixel circuits 30 is not limited. The first functional transistor T₀ may be a light-emitting control transistor, a threshold compensation transistor, or a gate reset transistor in the pixel circuit 30.

The pixel circuits 30 are arranged in a pixel circuit row 30H along a first direction x. The scan line 20 extends along the first direction x and is connected to control terminals of the plurality of first functional transistors T₀ in the pixel circuit row 30H. The shift register unit 10 includes a first shift register unit 10a and a second shift register unit 10b. In the first direction x, the first shift register unit 10a is provided at a side of the scan line 20, and the second shift register unit 10b is provided at the other side thereof. An output terminal of the first shift register unit 10a is connected to an end of the scan line 20, and an output terminal of the second shift register unit 10b is connected to the other end of the scan line 20. A plurality of first shift register units 10a in a cascade configuration form a first shift driving circuit 1, and a plurality of second shift register units 10b in a cascade configuration form a second shift driving circuit 2. The first shift register unit 10a and the second shift register unit 10b each provide scan signals to the scan line 20 from an end of the scan line 20. The high level in the scan signal is the enable level that drives the n-type transistor in the pixel circuit 30. FIG. 4 illustrates that two sets of shift driving circuits drive the pixel circuit row 30H from both sides, which can balance the voltage drop differences of the scan signals at different positions in the first direction x, thereby improving display uniformity. In some embodiments, the shift register units 10 are provided at a single side of the scan line 20, that is, drive the pixel circuit row 30H from one side, which is not shown in the drawings herein.

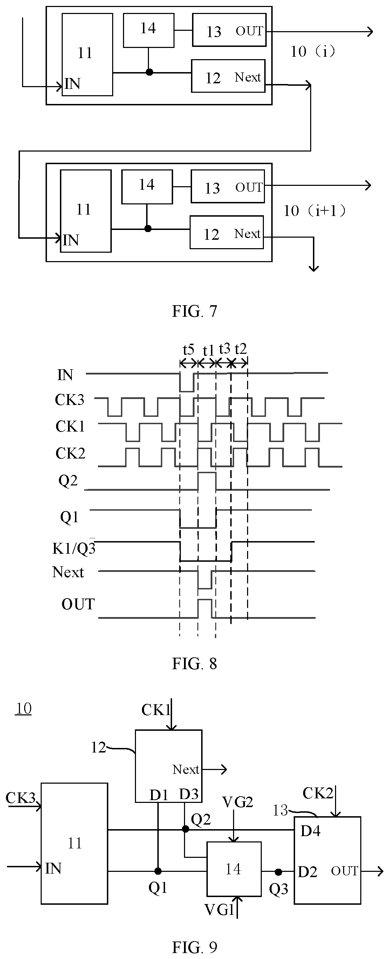

FIG. 5 is a schematic diagram of a shift register unit according to an embodiment of the present disclosure. FIG. 6 is a schematic diagram of a further shift register unit according to an embodiment of the present disclosure. FIG. 7 is a schematic diagram of a cascade configuration of shift register units according to an embodiment of the present disclosure. As shown in FIG. 5 and FIG. 6, the shift register unit 10 includes an input module 11, a stage transmission module 12, an output module 13, and a control module 14. The stage transmission module 12 includes a first control terminal D1, and is configured to output a low-level signal based on a signal from the first control terminal D1 and a first clock signal CK1. The output module 13 includes a second control terminal D2, and is configured to output a high-level signal based on a signal from the second control terminal D2 and a second clock signal CK2. The first clock signal CK1 and the second clock signal CK2 have opposite phases. The input module 11 writes a voltage to a first node Q1 based on a signal from an input terminal IN. A control terminal of the control module 14 and an output terminal of the input module 11 are connected to the first node Q1, and an output terminal of the control module 14 is connected to one of the first control terminal D1 and the second control terminal D2. FIG. 5 illustrates that the second control terminal D2 is connected to the output terminal of the control module 14, and the first control terminal D1 is connected to the first node Q1. FIG. 6 illustrates that the first control terminal D1 is connected to the output terminal of the control module 14, and the second control terminal D2 is connected to the first node Q1.

FIG. 7 illustrates, by taking the structure shown in FIG. 5 as an example, a cascaded configuration of the shift register units 10. As shown in FIG. 7, an output terminal Next of the stage transmission module 12 in the i-th stage shift register unit 10(i) is connected to the input terminal IN of the input module 11 in the (i+1)-th stage shift register unit 10(i +1), where i is a positive integer. The signal output by the stage transmission module 12 is provided to the next-stage shift register unit 10 to achieve a cascaded configuration of the plurality of shift register units 10. The signal output by the output module 13 serves as the scan signal to drive the pixel circuit row 30H. The high-level signal output by the output module 13 is an enable signal. With reference to FIG. 4, an output terminal OUT of the output module 13 is connected to the scan line 20, thereby utilizing the high-level enable signal to drive the n-type transistor in the pixel circuit 30.

In an embodiment of the present disclosure, the shift register unit 10 includes the stage transmission module 12, the output module 13, and the control module 14. The signal output by the stage transmission module 12 is transmitted to the next-stage shift register unit 10 to achieve cascading, and the signal output by the output module 13 serves as the scan signal. A control terminal of the control module 14 is connected to the first node Q1. One of the first control terminal D1 of the stage transmission module 12 and the second control terminal D2 of the output module 13 is connected to the first node Q1, and the other one of the first control terminal D1 of the stage transmission module 12 and the second control terminal D2 of the output module 13 is connected to the output terminal of the control module 14, so that the first control terminal D1 and the second control terminal D2 are controlled by their respective signal lines. In this way, the mutual influence between the first clock signal CK1 received by the stage transmission module 12 and the second clock signal CK2 received by the output module 13 can be isolated, and the signal transition of the second clock signal CK2 does not affect the waveform of the signal from the output terminal of the stage transmission module 12, thereby improving the performance reliability of the shift driving circuit and the yield of display panel products.

FIG. 8 is a timing diagram according to an embodiment of the present disclosure that can be used to drive the shift register unit illustrated in FIG. 5 or FIG. 6. As shown in FIG. 8, operation period of the shift register unit includes a fifth period t5 and a first period t1. During the fifth period t5, the input module 11 writes a low-level signal to the first node Q1 based at least on an input signal from the input terminal IN and a third clock signal CK3, and the first node Q1 is at a low potential. During the first period t1, the first node Q1 is maintained at the low potential. During the first period t1, the control module 14, under the control of the first node Q1, is turned on and provides a control signal K1 to one of the first control terminal D1 and the second control terminal D2. During this period, the control signal K1 is in phase with the potential of the first node Q1. That is, during the first period t1, the first control terminal D1 and the second control terminal D2 are both at a low potential. The stage transmission module 12, under the control of the signal from the first control terminal D1, is turned on, and the output terminal Next of the stage transmission module 12 outputs the low-level signal provided by the first clock signal CK1. The output module 13, under the control of the signal from the second control terminal D2, is turned on, and the output terminal OUT of the output module 13 outputs the high-level signal provided by the second clock signal CK2. In an embodiment of the present disclosure, an additional control module 14 is provided in the shift register unit 10. The input terminal of the control module 14 is connected to the first node Q1, and the output signal of the control module 14 is set to be in phase with the potential of the first node Q1 during the first period t1. In this way, the output signals of the first node Q1 and the control module 14 can be used to control the stage transmission module 12 to output a low level and to control the output module 13 to output a high level, respectively, so as to avoid the mutual influence between the first clock signal CK1 and the second clock signal CK2, and the signal transition of the second clock signal CK2 from low to high does not affect the waveform of the signal from the output terminal of the stage transmission module 12, thereby improving the performance reliability of the shift driving circuit and the yield of display panel products.

In some embodiments, FIG. 9 is a schematic diagram of a further shift register unit according to an embodiment of the present disclosure. As shown in FIG. 9, the other output terminal of the input module 11 is connected to a second node Q2. The input module 11 is configured to write voltages to the first node Q1 and the second node Q2, respectively, based at least on the input signal from the input terminal IN and the third clock signal CK3. One control terminal of the control module 14 is connected to the first node Q1, and the other control terminal of the control module 14 is connected to the second node Q2. The output terminal of the control module 14 and one of the first control terminal D1 and the second control terminal D2 are connected to a third node Q3. FIG. 9 illustrates that the output terminal of the control module 14 and the second control terminal D2 are connected to the third node Q3. Furthermore, the stage transmission module 12 further includes a third control terminal D3. The stage transmission module 12, under the control of the third control terminal D3, inputs a high-level signal. The output module 13 further includes a fourth control terminal D4. The output module 13, under the control of the fourth control terminal D4, inputs a low-level signal. The third control terminal D3 and the fourth control terminal D4 are connected to the second node Q2, respectively.

The control module 14 is configured to write a low-level signal to the third node Q3 based on a voltage of the first node Q1 and a first voltage signal VG1, and is further configured to write a high-level signal to the third node Q3 based on a voltage of the second node Q2, the first clock signal CK1, and a second voltage signal VG2. In some embodiments, the first voltage signal VG1 is the low-level signal VGL, and the second voltage signal VG2 is the high-level signal VGH.

In an embodiment of the present disclosure, the input module 11 is configured to write signals to the first node Q1 and the second node Q2, respectively. One control terminal of the control module 14 is connected to the first node Q1, and the other control terminal thereof is connected to the second node Q2. Moreover, the output terminal of the control module 14 and one of the first control terminal D1 and the second control terminal D2 are connected to the third node Q3. In this way, the control module 14 can write both a high potential and a low potential to the third node Q3, thereby achieving complete control of the control terminal connected to the control module 14. For example, when the second control terminal D2 is connected to the third node Q3, the control module 14 writes a low potential to the third node Q3, so that the second control terminal D2 controls the output terminal OUT to output the signal provided by the second clock signal CK2. The control module 14 writes a high potential to the third node Q3, so that the second control terminal D2 controls the output terminal OUT to stop outputting the signal provided by the second clock signal CK2.

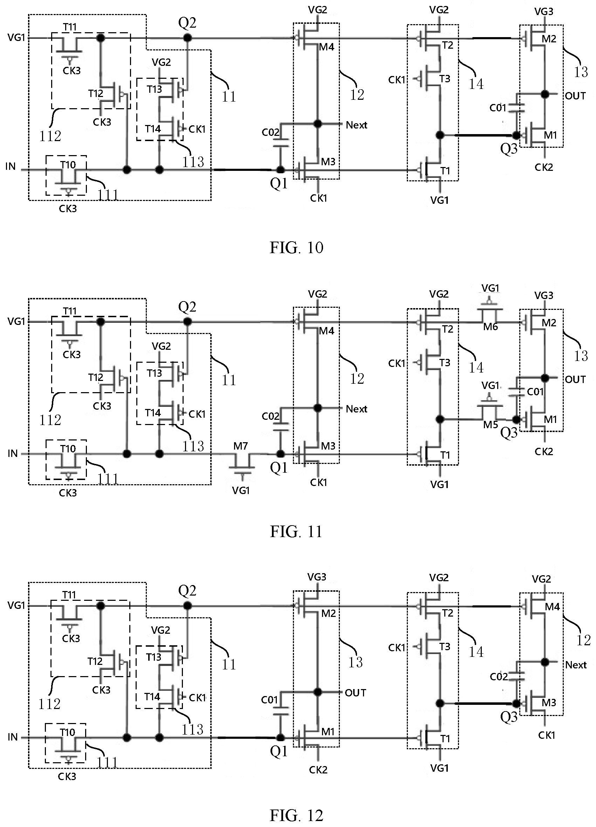

In some embodiments, FIG. 10 is a schematic diagram of a further shift register unit according to an embodiment of the present disclosure. As shown in FIG. 10, the control module 14 includes a first transistor T1, a second transistor T2 and a third transistor T3. A control terminal of the first transistor T1 is connected to the first node Q1, a first terminal of the first transistor T1 receives the first voltage signal VG1, and a second terminal of the first transistor T1 is connected to the output terminal of the control module 14. A control terminal of the second transistor T2 is connected to the second node Q2, a first terminal of the first transistor T1 receives the second voltage signal VG2, and a second terminal of the first transistor T1 is connected to a first terminal of the third transistor T3. A control terminal of the third transistor T3 receives the first clock signal CK1, and a second terminal of the first transistor T1 is connected to the output terminal of the control module 14.

With reference to the timing diagram shown in FIG. 8, the operation periods of the shift register unit include the first period t1 and a second period t2. During the first period t1, the first node Q1 is at a low potential. During the second period t2, the second node Q2 is at a low potential. During the first period t1, the control module 14, under the control of the first node Q1, is turned on and writes the low-level signal of the first voltage signal VG1 to the third node Q3. In an embodiment, the first transistor T1 is turned on under the control of the low potential of the first node Q1, and the low-level signal of the first voltage signal VG1 is written to the third node Q3, so that the third node Q3 is at a low potential.

During the second period t2, the control module 14, under the control of the second node Q2 and the first clock signal CK1, is turned on and writes the high-level signal of the second voltage signal VG2 to the third node Q3. In an embodiment, the second transistor T2 is turned on under the control of the low potential of the second node Q2, the third transistor T3 is turned on under the control of the low potential of the first clock signal CK1, and the high-level signal provided by the second voltage signal VG2 is written to the third node Q3, so that the third node Q3 is at a high potential.

With respect to the module controlled by the third node Q3, taking as an example that, as shown in FIG. 10, one control terminal of the output module 13 is connected to the third node Q3, during the first period t1, the third node Q3 is at a low potential, and the output module 13 is controlled to output a high-level signal provided by the second clock signal CK2. During the second period t2, the third node Q3 is at a high potential, the corresponding output transistor of the output module 13 is controlled to turn off.

As shown in FIG. 10, the output module 13 includes the first output transistor M1 and the second output transistor M2. The stage transmission module 12 includes the third output transistor M3 and the fourth output transistor M4. The control terminal of the first output transistor M1 is the second control terminal D2 (with reference to FIG. 9), the first terminal of the first output transistor M1 receives the second clock signal CK2, and the second terminal of the first output transistor M1 is connected to the output terminal OUT of the output module 13. A control terminal of the second output transistor M2 (i.e., the fourth control terminal D4 shown in FIG. 9) is connected to the second node Q2, the first terminal of the second output transistor M2 receives the third voltage signal VG3, and the second terminal of the second output transistor M2 is connected to the output terminal OUT of the output module 13. The control terminal of the third output transistor M3 is the first control terminal D1, the first terminal of the third output transistor M3 receives the first clock signal CK1, and the second terminal of the third output transistor M3 is connected to the output terminal Next of the stage transmission module 12. The control terminal of the fourth output transistor M4 (i.e., the third control terminal D3 shown in FIG. 9) is connected to the second node Q2, the first terminal of the fourth output transistor M4 receives the second voltage signal VG2, and the second terminal of the fourth output transistor M4 is connected to the output terminal Next of the stage transmission module 12. The third voltage signal VG3 is a low-level signal, and the second voltage signal VG2 is a high-level signal.

FIG. 10 illustrates that the shift register unit further includes a first voltage-stabilizing capacitor C01. One plate of the first voltage-stabilizing capacitor C01 is connected to the output terminal OUT of the output module 13, and the other plate of the first voltage-stabilizing capacitor C01 is connected to a control terminal of the first output terminal M1. The shift register unit further includes a second voltage-stabilizing capacitor C02. One plate of the second voltage-stabilizing capacitor C02 is connected to the output terminal Next of the stage transmission module 12, and the other plate of the second voltage-stabilizing capacitor C02 is connected to a control terminal of the third output terminal M3.

With reference to the timing diagram shown in FIG. 8, during the first period t1, the first node Q1 is at a low potential, and the second node Q2 is at a high potential. During the first period t1, the third output transistor M3 of the stage transmission module 12 is turned on under the control of the first node Q1, and the low level of the first clock signal CK1 is provided to the output terminal Next of the stage transmission module 12, so that the output terminal Next of the stage transmission module 12 outputs a low-level signal. The first transistor T1 of the control module 14 is turned on under the control of the first node Q1, and the low level of the first voltage signal VG1 is provided to the output terminal of the control module 14, so that a low-level signal is written to the third node Q3. The first output transistor M1 of the output module 13 is turned on under the control of the low level of the third node Q3, and the high-level signal of the second clock signal CK2 is provided to the output terminal OUT of the output module 13, so that the output terminal OUT of the output module 13 outputs a high-level signal. In this way, the output signals of the first node Q1 and the control module 14 can be used to control the stage transmission module 12 to output a low level and control the output module 13 to output a high level, respectively, so that the mutual influence between the first clock signal CK1 and the second clock signal CK2 is avoided, and the signal transition of the second clock signal CK2 from low to high does not affect the waveform of the signal from the output terminal of the stage transmission module 12, thereby improving the performance reliability of the shift driving circuit and the yield of display panel products. In addition, during the first period t1, the transition of the first clock signal CK1 from high to low can pull down the potential of the first node Q1, thereby increasing the turn-on degree of the third output transistor M3, and further enabling the output terminal Next of the stage transmission module 12 to better output a low-level signal.

In addition, during the second period t2, the first node Q1 is at a high level, and the second node Q2 is at a low level. During the second period t2, the fourth output transistor M4 of the stage transmission module 12 is turned on under the control of the second node Q2, and the high level of the second voltage signal VG2 is provided to the output terminal Next of the stage transmission module 12, so that the output terminal Next of the stage transmission module 12 outputs a high-level signal. The second transistor T2 of the control module 14 is turned on under the control of the second node Q2, the third transistor T3 is turned on under the control of the low level of the first clock signal CK1, and the high level of the second voltage signal VG2 is provided to the third node Q3, so that the third node Q3 is at a high potential to control the first output transistor M1 to turn off. In addition, the second output transistor M2 of the output module 13 is also turned on under the control of the second node Q2, and the low level of the third voltage signal VG3 is provided to the output terminal OUT of the output module 13, so that the output terminal OUT of the output module 13 outputs a low-level signal.

In some embodiments, both the first voltage signal VG1 and the third voltage signal VG3 provide low-level signals. The voltage value of the first voltage signal VG1 is VGL1, and the voltage value of the third voltage signal VG3 is VGL2, where VGL1≤VGL2. In some embodiments of the present disclosure, the signal output by the output module 13 serves as a scan signal. By setting VGL1≤VGL2, the second output terminal M2 can be turned off more completely during the period in which the control terminal of the first output terminal M1 is at a low potential and the control terminal of the second output terminal M2 is at a high potential. As a result, the high-level signal output by the output terminal OUT of the output module 13 is more stable, thereby enabling the shift register unit to drive the pixel circuit more stably and improving the performance reliability of the display panel.

In some embodiments, FIG. 11 is a schematic diagram of a further shift register unit according to an embodiment of the present disclosure. As shown in FIG. 11, the shift register unit includes a first protection transistor M5 connected between the output terminal of the control module 14 and the third node Q3. A control terminal of the first protection transistor M5 receives the first voltage signal VG1. The first protection transistor M5 can protect the transistor that writes a signal to the output terminal of the control module 14 when the potential of the third node Q3 is excessively low, thereby preventing the transistor from being broken down.

As shown in FIG. 11, the shift register unit includes a second protection transistor M6 connected between the second node Q2 and the other control terminal of the output module 13. A control terminal of the second protection transistor M6 receives the first voltage signal VG1. The second protection transistor M6 can protect the transistor that writes a signal to the second node Q2 when the potential of the second output transistor M2 is excessively low, thereby preventing the transistor from being broken down.

In some embodiments, as shown in FIG. 11, the shift register unit further includes a third protection transistor M7 connected between the output terminal of the input module 11 and the first node Q1. A control terminal of the third protection transistor M7 receives the first voltage signal VG1.

In some embodiments, FIG. 12 is a schematic diagram of a further shift register unit according to an embodiment of the present disclosure. As shown in FIG. 12, one control terminal of the control module 14 is connected to the first node Q1, and the other control terminal of the control module 14 is connected to the second node Q2. The output terminal of the control module 14 and the control terminal of the third output transistor M3 of the stage transmission module 12 are connected to the third node Q3. The control terminal of the first output transistor M1 of the output module 13 is connected to the first node Q1. The control terminal of the third output terminal M3 is the first control terminal, and the control terminal of the first output transistor M1 is the second control terminal. That is, the first control terminal is connected to the output terminal of the control module 14, and the second control terminal is connected to the first node Q1. In FIG. 12, the timing shown in FIG. 8 may be adopted for driving, and the operation process of the control module 14 will not be repeated here. In this embodiment, the high level of the second clock signal CK2 is provided, under the control of the first node Q1, to the output terminal OUT of the output module 13, so that the output module 13 outputs a high-level signal. The low level of the first clock signal CK1 is provided, under the control of the output signal of the control module 14, to the output terminal Next of the stage transmission module 12, so that the stage transmission module 12 outputs a low-level signal. In this way, the mutual influence between the first clock signal CK1 received by the stage transmission module 12 and the second clock signal CK2 received by the output module 13 can be isolated, and the signal transition of the second clock signal CK2 does not affect the waveform of the signal from the output terminal of the stage transmission module 12, thereby improving the performance reliability of the shift driving circuit and the yield of display panel products.

In some embodiments, as shown in FIG. 10, the input module 11 includes a first sub-module 111, a second sub-module 112, and a third sub-module 113. The first sub-module 111 is configured to write a voltage to the first node Q1 based on an input signal IN (using the same reference sign as the input terminal IN) and the third clock signal CK3. The second sub-module 112 is configured to write a voltage to the second node Q2 based on the third clock signal CK3, the output signal of the first sub-module 111, and the first voltage signal VG1. The third sub-module 113 is configured to write a high level to the first node Q1 based on the output signal of the second sub-module 112, the first clock signal CK1, and the second voltage signal VG2. In some embodiments of the present disclosure, the input module 11 is provided with three sub-modules, and the three sub-modules respectively cooperate with the input signal and the clock signals to write voltage signals to the first node Q1 and the second node Q2, respectively.

As shown in FIG. 10, the first sub-module 111 includes a tenth transistor T10. A control terminal of the tenth transistor T10 receives the third clock signal CK3, a first terminal of the tenth transistor T10 receives the input signal IN, and a second terminal of the tenth transistor T10 is connected to the first node Q1. The second sub-module 112 includes an eleventh transistor T11 and a twelfth transistor T12. A control terminal of the eleventh transistor T11 receives the third clock signal CK3, a first terminal of the eleventh transistor T11 receives the first voltage signal VG1, and a second terminal of the eleventh transistor T11 is connected to the second node Q2. A control terminal of the twelfth transistor T12 is connected to the second terminal of the tenth transistor T10 (i.e., connected to the output terminal of the first sub-module 111), a first terminal of the twelfth transistor T12 receives the third clock signal CK3, and a second terminal of the twelfth transistor T12 is connected to the second node Q2. The third sub-module 113 includes a thirteenth transistor T13 and a fourteenth transistor T14. A control terminal of the thirteenth transistor T13 is connected to the second node Q2 (i.e., connected to the output terminal of the second sub-module 112), a first terminal of the thirteenth transistor T13 receives the second voltage signal VG2, and a second terminal of the thirteenth transistor T13 is connected to a first terminal of the fourteenth transistor T14. A control terminal of the fourteenth transistor T14 receives the first clock signal CK1, and a second terminal of the fourteenth transistor T14 is connected to the first node Q1.

The shift register unit 10 according to the embodiment of FIG. 10 may be driven by adopting the timing shown in FIG. 8. The operation process of the input module 10 is described with reference to FIG. 8. The operation periods of the shift register unit 10 include the first period t1 (t2), the second period t2, a third period t3, and a fifth period t5. Within a period in which the shift register unit outputs a scan signal, the fifth period t5, the first period t1, the third period t3, and the second period t2 are sequentially arranged in chronological order.

During the fifth period t5, the tenth transistor T10 writes, under the control of the low level of the third clock signal CK3, the low level of the input signal IN to the first node Q1. The eleventh transistor T11 writes, under the control of the low level of the third clock signal CK3, the low level of the first voltage signal VG1 to the second node Q2. The twelfth transistor T12, under the control of the first node Q1, writes the low level of the third clock signal CK3 to the second node Q2. That is, during this period, the first sub-module 111 writes a low-level signal to the first node Q1 based on the input signal IN and the third clock signal CK3. The second sub-module 112 writes a low-level signal to the second node Q2 based on the third clock signal CK3, the output signal of the first sub-module 111, and the first voltage signal VG1. During the fifth period t5, the first node Q1 is at a low potential, and the second node Q2 is at a low potential.

During the first period t1, the tenth transistor T10 and the eleventh transistor T11 are turned off, under the control of the high level of the third clock signal CK3. The first node Q1 is at a low potential. The twelfth transistor T12 writes, under the control of the first node Q1, the high level of the third clock signal CK3 to the second node Q2. During this period, the first input sub-module 111 is turned off, and the second input sub-module 112 writes a high potential to the second node Q2 based on the potential of the output terminal of the first input sub-module 111 and the third clock signal CK3. During the first period t1, the first node Q1 is maintained at a low potential, and a high potential is written to the second node Q2.

During the third period t3, the tenth transistor T10 writes, under the control of the low level of the third clock signal CK3, the high level of the input signal IN to the first node Q1. The eleventh transistor T11 writes, under the control of the low level of the third clock signal CK3, the low level of the first voltage signal VG1 to the second node Q2. The thirteenth transistor T13 is turned on under the control of the second node Q2, and the fourteenth transistor T14 is turned off under the control of the high level of the first clock signal CK1. During this period, the first sub-module 111 writes a high-level signal to the first node Q1 based on the input signal IN and the third clock signal CK3. The second sub-module 112 writes a low-level signal to the second node Q2 based on the third clock signal CK3 and the first voltage signal VG1. The third sub-module 113 is still in the turned-off state. During the third period t3, the first node Q1 is at a high potential, and the second node Q2 is at a low potential.

During the second period t2, the tenth transistor T10 and the eleventh transistor T11 are turned off, under the control of the high level of the third clock signal CK3. The first node Q1 is at a high potential, and the second node Q2 is at a low potential. The thirteenth transistor T13 is turned on under the control of the second node Q2, the fourteenth transistor T14 is turned on under the control of the low level of the first clock signal CK1, and the high level of the second voltage signal VG2 is written to the first node Q1. During this period, the first sub-module 111 and the second sub-module 112 are turned off, the third sub-module 113 is turned on based on the low potential of the second node Q2 and the low-level signal of the first clock signal CK1, and the high-level signal of the second voltage signal VG2 is written to the first node Q1. During the second period t2, the first node Q1 is at a high potential, and the second node Q2 is at a low potential.

The structures of the input module 11 in FGI. 11 and FIG. 12 are the same as that in FIG. 10, and the operation process thereof can be understood with reference to the above description.

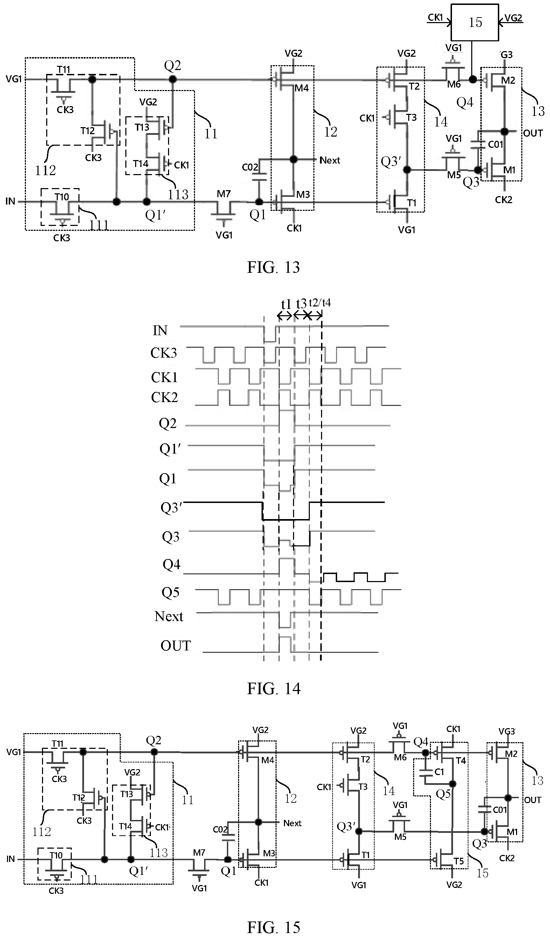

In some embodiments, FIG. 13 is a schematic diagram of a further shift register unit according to an embodiment of the present disclosure. As shown in FIG. 13, the output module 13 includes the first output transistor M1 and the second output transistor M2. The control terminal of the first output transistor M1 is connected to the output terminal of the control module 14, a first terminal of the first output transistor M1 receives the second clock signal CK2, and a second terminal of the first output transistor M1 is connected to the output terminal OUT of the output module 13. The control terminal of the second output transistor M2 is connected to the second node Q2, the first terminal of the second output transistor M2 receives the third voltage signal VG3, and the second terminal of the second output transistor M2 is connected to the output terminal OUT of output module 13. The shift register unit includes a coupling module 15. One control terminal of the coupling module 15 and the control terminal of the second output transistor M2 are connected to a fourth node Q4. The coupling module 15 is configured to pull down the potential of the fourth node Q4 via coupling at least during the period in which the fourth node Q4 is at a low potential. During the period in which the fourth node Q4 is at a low potential, the second output transistor M2 is turned on and provides the low-level signal of the third voltage signal VG3 to the output terminal OUT, so that the output module 13 outputs a low-level signal. In some embodiments of the present disclosure, the coupling module 15 is provided to act on the potential of the fourth node Q4, so that the potential of the fourth node Q4 is lower during the low-potential period, thereby ensuring that the second output transistor M2 can be turned on more completely and the output module 13 can output more complete low-level signals, and improving the performance reliability of the shift driving circuit.

FIG. 13 illustrates, as an example, the coupling module 15 provided in the embodiment in which the second control terminal (the control terminal of the first output transistor M1) is connected to the output terminal of the control module 14, and the first control terminal (the control terminal of the third output terminal M3) is connected to the first node Q1. In some embodiments, the coupling module 15 may also be provided in the embodiment in which the first control terminal (the control terminal of the third output terminal M3) is connected to the output terminal of the control module 14, and the second control terminal (the control terminal of the first output transistor M1) is connected to the first node Q1, as in the embodiment of FIG. 12, which is not further illustrated in the drawings.

In some embodiments, the second protection transistor M6 is provided in the embodiment of FIG. 12. The second protection transistor M6 is connected between the second node Q2 and the control terminal of the second output transistor M2.

In some embodiments, the first protection transistor M5 is provided in the embodiment of FIG. 12. The first protection transistor M5 is connected between the third node Q3 and the output terminal of the control module 14.

FIG. 14 is a further timing diagram according to an embodiment of the present disclosure. As shown in FIG. 14, the operation period of the shift register unit includes the third period t3 and a fourth period t4. During the third period t3 and the fourth period t4, the fourth node Q4 is at a low potential. The second protection transistor M6 is connected between the second node Q2 and the fourth node Q4, and the potential of the second node Q2 is in phase with the potential of the fourth node Q4. During the third period t3, the coupling module 15 writes, under the control of the fourth node Q4, the high-level signal of the first clock signal CK1 to a fifth node Q5 of the coupling module 15. During the fourth period t4, the coupling module 15 writes, under the control of the fourth node Q4, the low-level signal of the first clock signal CK1 to the fifth node Q5, and pulls down the potential of the fourth node Q4 based on the change in the potential of the fifth node Q5.

In some embodiments of the present disclosure, the fifth node Q5 is provided in the coupling module 15. During the third period t3, a low level is written to the fifth node Q5. During the fourth period t4, a high level is written to the fifth node Q5, and the change in the potential of the fifth node Q5 is used to pull down the fourth node Q4, so that the potential of the fourth node Q4 is lower during at least part of the low-potential period, thereby ensuring that the second output transistor M2 can be turned on more completely and the output module 13 can output more complete low-level signals, and improving the performance reliability of the shift driving circuit.

As shown in FIG. 14, the operation period of the shift register unit includes the first period t1. During the first period t1, the first node Q1 is at a low potential, and the fourth node Q4 is at a high potential. During the first period t1, the coupling module 15 writes, under the control of the first node Q1, the high potential of the second voltage signal VG2 to the fifth node Q5. During the first period t1, the fifth node Q5 of the coupling module 15 is reset, which can ensure the normal periodic operation of the coupling module 15.

In some embodiments, FIG. 15 is a schematic diagram of a further shift register unit according to an embodiment of the present disclosure. As shown in FIG. 15, the coupling module includes a fourth transistor T4, a fifth transistor T5, and a first capacitor C1. A control terminal of the fourth transistor T4 and the control terminal of the second output transistor M2 are connected to the fourth node Q4. A control terminal of the fifth transistor T5 is connected to the first node Q1. A first terminal of the fourth transistor T4 receives the first clock signal CK1. A second terminal of the fourth transistor T4, a second terminal of the fifth transistor T5, and one plate of the first capacitor C1 are connected to the fifth node Q5. A first terminal of the fifth transistor T5 receives the second voltage signal VG2. The other plate of the first capacitor C1 is connected to the control terminal of the fourth transistor T4. The second voltage signal VG2 provides a high-level signal.

The operation of the coupling module 15 in the embodiment of FIG. 15 will be described with reference to the timing shown in FIG. 14. As shown in FIG. 14, the operation period of the shift register unit includes the first period t1, the third period t3, and the fourth period t4. During the third period t3 and the fourth period t4, the second node Q2 and the fourth node Q4 are at a low potential. During the first period t1, the first node Q1 is at a low potential, and the fourth node Q4 is at a high potential.

During the first period t1, the fifth transistor T5 is turned on under the control of the low potential of the first node Q1, and writes the high potential of the second voltage signal VG2 to the fifth node Q5. During this period, the fifth node Q5 is reset.

During the third period t3, the fourth transistor T4 is turned on under the control of the low potential of the fourth node Q4 and writes the high-level signal of the first clock signal CK1 to the fifth node Q5. During this period, the voltage value of the fourth node Q4 is V1.

During the fourth period t4, the fourth transistor T4 writes, under the control of the low potential of the fourth node Q4, the low-level signal of the first clock signal CK1 to the fifth node Q5, and pulls down the fourth node Q4 based on the change in the potential of the fifth node Q5. During this period, the voltage value of the fourth node Q4 is V2, where V2<V1.

It can be understood that, after the fourth period t4 shown in FIG. 14, the third clock signal CK3 is at a low level, the input module 11 writes the low level of the first voltage signal VG1 to the second node Q2, and the potential of the fourth node Q4 changes accordingly, returning to the low potential as in the third period t3. Therefore, the potential of the fourth node Q4 exhibits potential fluctuations between higher and lower levels during the low-potential maintaining period.

In addition, in the embodiment of FIG. 15, when both the coupling module 15 and the control module 14 are provided, the coupling module 15 mainly functions when the fourth node Q4 is at a low potential (which is also when the second node Q2 is at a low potential), whereas during part of the period in which the first node Q1 is at a low potential, the nodes of the coupling module 15 need to be reset. The control module 14 mainly functions when the first node Q1 is at a low potential, but it also performs certain operations during the period in which the second node Q2 is at a low potential.

With reference to FIG. 14, during the first period t1, the first node Q1 is at a low potential, the second node Q2 is at a high potential, and the fourth node Q4 is at a high potential. The fifth transistor T5 of the coupling module 15 is turned on, and writes the high level to the fifth node Q5 to reset the fifth node Q5. The first transistor T1 of the control module 14 is turned on under control of the first node Q1, and outputs the low-level signal of the first voltage signal VG1, so that the third node Q3 is at a low potential. The first output transistor M1 of the output module 13 is turned on under the control of the low potential of the third node Q3, to output the high-level signal of the second clock signal CK2, so that the output terminal OUT of the output module 13 outputs a high level. As shown in FIG. 14, during the first period t1, the voltage of the second clock signal CK2 transitions from low to high, so as to raise the potential of the third node Q3 via coupling. During the subsequent period, the voltage of the second clock signal CK2 transitions from high to low, so as to pull down the third node Q3 again. In other words, the low potential of the third node Q3 exhibits a certain degree of potential fluctuation. In addition, during this period, the third output transistor M3 of the stage transmission module 12 is turned on under the control of the low potential of the first node Q1, to provide the low level of the first clock signal CK1 to the output terminal, so that the output terminal Next of the stage transmission module 12 outputs a low level. The transition of the voltage of the first clock signal CK1 from high to low pulls down the potential of the first node Q1.

FIG. 15 further indicates a node Q1' and a node Q3'. The potential of the node Q1' is the same as the potential of the output terminal of the output module 11, and the potential of the node Q3' is the same as the potential of the output terminal of control module 14. During the first period t1, the node Q1' is at a low potential, and the node Q3' is at a low potential.

During the third period t3, the first node Q1 is at a high potential, the second node Q2 is at a low potential, and the fourth node Q4 is at a low potential. The fourth transistor T4 of the coupling module 15 is turned on under the control of the low potential of the fourth node Q4 and writes the high level of the first clock signal CK1 to the fifth node Q5. The first transistor T1 of the control module 14 is turned off under the control of the first node Q1, the second transistor T2 is turned on under the control of the second node Q2, and the third transistor T3 is turned off under the control of the high level of the first clock signal CK1, so that the output terminal of the control module 14 is maintained at a low potential, and both the node Q3' and the third node Q3 are at a low potential. During this period, the fourth output transistor M4 of the stage transmission module 12 is turned on under the control of the low potential of the second node Q2, and the stage transmission module 12 outputs a high-level signal. The second output transistor M2 of the output module 13 is turned on under the control of the low potential of the fourth node Q4, and the output module 13 outputs a low-level signal.

During the fourth period t4, the first node Q1 is at a high potential, the second node Q2 is at a low potential, and the fourth node Q4 is at a low potential. The fourth transistor T4 of the coupling module 15 is turned on under the control of the low potential of the fourth node Q4, and writes the low level of the first clock signal CK1 to the fifth node Q5. The fifth node Q5 transitions from a high potential to a low potential, and the potential of the fourth node Q4 is pulled down in a coupled manner by the coupling effect of the first capacitor C1. During this period, the first clock signal CK1 is a low-level signal. The second transistor T2 of the control module 14 is turned on under the control of the second node Q2, and the third transistor T3 is turned on under the control of the low level of the first clock signal CK1, so that the high level of the second voltage signal VG2 is provided to the output terminal of the control module 14, and both the node Q3' and the third node Q3 are at a high potential.

With reference to the timing diagram shown in FIG. 8 and the relevant description of the operation periods of the control module 14 in the embodiment of FIG. 10, it can be understood that the operation of the control module 14 during the fourth period t4 is the same as that during the second period t2 in the timing diagram of FIG. 8. The fourth period t4 is equal to the second period t2 in which the control module 14 operates.

In addition, the input module 11 in FIG. 15 is configured to write voltages to the first node Q1 and the second node Q2, respectively. The operation process of the input module 11 can be understood with reference to the relevant description in the embodiments of FIG. 8 and FIG. 10, and will not be repeated here.

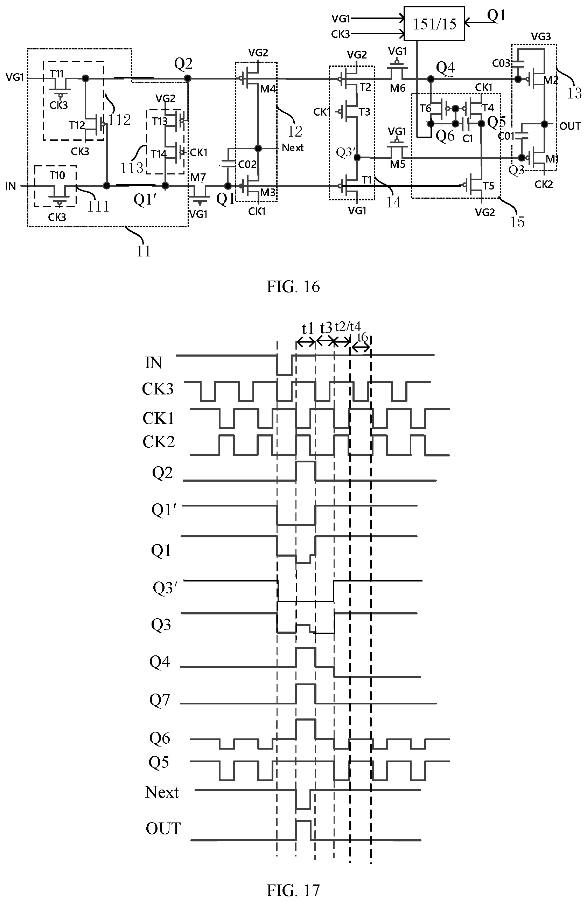

In some embodiments, FIG. 16 is a schematic diagram of a further shift register unit according to an embodiment of the present disclosure. As shown in FIG. 16, the coupling module 15 includes the fourth transistor T4, the fifth transistor T5, the first capacitor C1, a sixth transistor T6, and an input sub-module 151. The control terminal of the fourth transistor T4 is connected to the fourth node Q4 through the sixth transistor T6. The control terminal of the fifth transistor T5 is connected to the first node Q1. The first terminal of the fourth transistor T4 receives the first clock signal CK1. The second terminal of the fourth transistor T4, the second terminal of the fifth transistor T5, and one plate of the first capacitor C1 are connected to the fifth node Q5. The first terminal of the fifth transistor T5 receives the second voltage signal VG2. The other plate of the first capacitor C1 is connected to the control terminal of the fourth transistor T4. A control terminal of the sixth transistor T6 is connected to the control terminal of the fourth transistor T4. A first terminal and the control terminal of the sixth transistor T6 are connected to a sixth node Q6. A second terminal of the sixth transistor T6 is connected to the fourth node Q4. That is, the first terminal and the control terminal of the sixth transistor T6, and one plate of the first capacitor C1 are connected to the sixth node Q6. An output terminal of the input sub-module 151 is connected to the sixth node Q6. The input sub-module 151 is configured to write a voltage to the sixth node Q6 based on the first voltage signal VG1, the third clock signal CK3, and the potential of the first node Q1.

FIG. 17 is a further timing diagram according to an embodiment of the present disclosure that can be used to drive the shift register unit illustrated in FIG. 16. As shown in FIG. 17, the operation period of the shift register unit includes the first period t1, the third period t3, and the fourth period t4. During the third period t3 and the fourth period t4, the fourth node Q4 is at a low potential, and the first node Q1 is at a high potential. During the first period t1, the first node Q1 is at a low potential, and the fourth node Q4 is at a high potential. The second protection transistor M6 is connected between the second node Q2 and the fourth node Q4, and the potential of the second node Q2 is in phase with the potential of the fourth node Q4. The operation of the coupling module 15 includes the following processes.

During the first period t1, the fifth transistor T5 writes, under the control of the low potential of the first node Q1, the high potential of the second voltage signal VG2 to the fifth node Q5. The input sub-module 151 writes, under the control of the first node Q1, the high potential to the sixth node Q6.

During the third period t3, the input sub-module 151 is turned on under the control of the low level of the third clock signal CK3, and writes the low level of the first voltage signal VG1 to the sixth node Q6. The fourth transistor T4 writes, under the control of the sixth node Q6, the high-level signal of the first clock signal CK1 to the fifth node Q5. The sixth transistor T6 conducts, under the control of the sixth node Q6, the path between the fourth node Q4 and the sixth node Q6. During this period, the voltage value of the fourth node Q4 is V1.

During the fourth period t4, the input sub-module 151 is turned off under the control of the high level of the third clock signal CK3, and the sixth node Q6 is maintained at a low potential. The fourth transistor T4 writes, under the control of the sixth node Q6, the low-level signal of the first clock signal CK1 to the fifth node Q5. Due to the action of the first capacitor C1, the change in the potential of the fifth node Q5 pulls down the potential of the sixth node Q6. The sixth transistor T6 conducts, under the control of the sixth node Q6, the path between the fourth node Q4 and the sixth node Q6, and pulls down the potential of the fourth node Q4. During this period, the voltage value of the fourth node Q4 is V2, and V2 is less than V1.

In an embodiment, the control terminal and the first terminal of the sixth transistor T6 are both connected to the sixth node Q6. The sixth transistor T6 forms a diode-like structure, so that it has a unidirectional conduction characteristic. During the period t6 after the fourth period t4, in which the first clock signal CK1 is at a high level, the low potential of the sixth node Q6 controls the fourth transistor T4 to write the high-level signal of the first clock signal CK1 to the fifth node Q5. The change in the potential of the fifth node Q5 raises the potential of the sixth node Q6. At this time, the sixth node Q6 is at a low potential, but this potential is higher than the potential of the sixth node Q6 during the fourth period t4. Since the sixth transistor T6 forms the diode-like structure, it can prevent the sixth node Q6 from discharging to the fourth node Q4, so that the fourth node Q4 is still at the lower potential. In this way, the low-potential of the fourth node Q4 is more stable, and the output module 13 can output more complete low-level signals.

In addition, in this embodiment, the operation of the control module 14 can be understood with reference to the embodiment of FIG. 15, which will not be repeated herein.

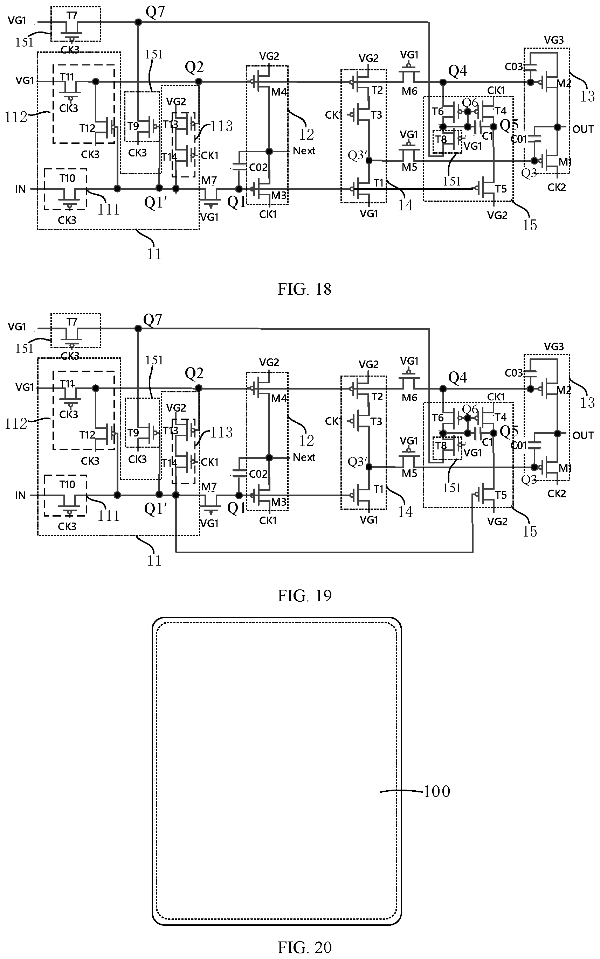

In some embodiments, FIG. 18 is a schematic diagram of a further shift register unit according to an embodiment of the present disclosure. As shown in FIG. 18, the input sub-module 151 includes a seventh transistor T7, an eighth transistor T8, and a ninth transistor T9. A control terminal of the seventh transistor T7 receives the third clock signal CK3, a first terminal of the seventh transistor T7 receives the first voltage signal VG1, and a second terminal of the seventh transistor T7 is connected to a first terminal of the eighth transistor T8. A control terminal of the eighth transistor T8 receives the first voltage signal VG1, and a second terminal of the eighth transistor T8 is connected to the sixth node Q6. A control terminal of the ninth transistor T9 is connected to the first node Q1, a first terminal of the ninth transistor T9 receives the third clock signal CK3, and a second terminal of the ninth transistor T9 is connected to the second terminal of the seventh transistor T7. During the first period t1, the ninth transistor T9 is turned on under control of the low level of the first node Q1, and writes the high-level signal of third clock signal CK3 to the seventh node Q7, and writes the high level to the sixth node Q6 through the eighth transistor T8, so that the sixth node Q6 is at a high potential. During the third period t3, the seventh transistor T7 is turned on under the control of the low level of the third clock signal CK3, and the eighth transistor T8 is turned on under the control of the low level of the first voltage signal VG1, so that the low-level signal of the first voltage signal VG1 is written to the sixth node Q6. During the fourth period t4, the high level of the third clock signal CK3 controls the seventh transistor T7 to be turned off, so that the sixth node Q6 is maintained at a low-level signal.

As shown in FIG. 18, the shift register unit includes the third protection transistor M7. The control terminal of the third protection transistor M7 receives the first voltage signal VG1, the first terminal of the third protection transistor M7 is connected to one output terminal of the input module 11, and the second terminal of the third protection transistor M7 is connected to the first node Q1. The third protection transistor M7 can protect the transistor connected to the first terminal of the third protection transistor M7 when the potential of the first node Q1 is excessively low, thereby preventing the transistor from breakdown.

In some embodiments, FIG. 19 is a schematic diagram of a further shift register unit according to an embodiment of the present disclosure. As shown in FIG. 19, one output terminal of the input module 11 is connected to the node Q1', the third protection transistor M7 is connected between the node Q1' and the first node Q1. The control terminal of the fifth transistor T5 in the coupling module 15 is connected to the node Q1', that is, connected to the first terminal of the third protection transistor M7. Such configuration ensures that the potential of the control terminal of the fifth transistor T5 is not affected by the potential transition of the first clock signal CK1.

The shift register unit according to the embodiment of FIG. 19 may be driven by adopting the timing shown in FIG. 17. Its operation process can be understood with reference to the above related embodiments, which will not be repeated herein.

In some embodiments, each transistor in the shift register unit according to the embodiments of the present disclosure is a p-type transistor.

Based on the same inventive concept, an embodiment of the present disclosure further provides a display apparatus. FIG. 20 is a schematic diagram of a display apparatus according to an embodiment of the present disclosure. As shown in FIG. 20, the display apparatus includes the display panel 100 according to any one of the embodiments of the present disclosure. The structure of the display panel has been described in the above embodiments, which will not be repeated herein. The display apparatus according to an embodiment of the present disclosure may be, for example, an electronic device such as a mobile phone, a tablet, a television, or a smart wearable product.

The above description is merely preferred embodiments of the present disclosure and is not intended to limit the present disclosure. Any modifications, equivalent substitutions, improvements, etc. made within the spirit and principles of the present disclosure should fall within the protection scope of the present disclosure.

It should be noted that the above embodiments are only used to illustrate the technical solutions of the present disclosure, rather than to limit it. Although the present disclosure has been described in detail with reference to the above embodiments, those skilled in the art should understand that they can still modify the technical solutions described in the above embodiments, or replace some or all of the technical features therein with equivalents. However, these modifications or replacements do not cause the essence of the corresponding technical solutions to deviate from the scope of the technical solutions of the embodiments of the present disclosure.

## Claims

1. A display panel, comprising a plurality of shift register units in a cascade configuration, wherein
at least one of the shift register units comprises an input module, a stage transmission module, an output module, and a control module; and an output terminal of a stage transmission module in an i-th stage shift register unit is connected to an input terminal of an input module in an (i+1)-th stage shift register unit, wherein i is a positive integer;
the stage transmission module comprises a first control terminal, and the stage transmission module is configured to output a low-level signal based on a signal from the first control terminal and a first clock signal;
the output module comprises a second control terminal, and the output module is configured to output a high-level signal based on a signal from the second control terminal and a second clock signal, wherein the first clock signal and the second clock signal have opposite phases; and
a control terminal of the control module and an output terminal of the input module are connected to a first node, one of the first control terminal and the second control terminal is connected to an output terminal of the control module, and the other one of the first control terminal and the second control terminal is connected to the first node.

2. The display panel according to claim 1, wherein an operation period of the shift register unit comprises a first period; and
during the first period, the control module is turned on and provides a control signal to the one of the first control terminal and the second control terminal under control of the first node, the stage transmission module is turned on and outputs the low-level signal provided by the first clock signal under control of the signal from the first control terminal, and the output module is turned on and outputs the high-level signal provided by the second clock signal under control of the signal from the second control terminal.

3. The display panel according to claim 1, wherein
another output terminal of the input module is connected to a second node, another control terminal of the control module is connected to the second node, and the output terminal of the control module and the one of the first control terminal and the second control terminal are connected to a third node; and
the control module is configured to write a low-level signal to the third node based on a voltage of the first node and a first voltage signal, and is further configured to write a high-level signal to the third node based on a voltage of the second node, the first clock signal and a second voltage signal.

4. The display panel according to claim 3, wherein an operation period of the shift register unit comprises a first period and a second period;
during the first period, the control module is turned on and writes the low-level signal of the first voltage signal to the third node under control of the first node; and
during the second period, the control module is turned on and writes the high-level signal of the second voltage signal to the third node under control of the second node and the first clock signal.

5. The display panel according to claim 3, wherein the control module comprises a first transistor, a second transistor and a third transistor; and
a control terminal of the first transistor is connected to the first node, a first terminal of the first transistor receives the first voltage signal, and a second terminal of the first transistor is connected to the output terminal of the control module; a control terminal of the second transistor is connected to the second node, a first terminal of the second transistor receives the second voltage signal, and a second terminal of the second transistor is connected to a first terminal of the third transistor; a control terminal of the third transistor receives the first clock signal, and a second terminal of the third transistor is connected to the output terminal of the control module.

6. The display panel according to claim 3, wherein the second control terminal is connected to the third node; and
the shift register unit comprises a first protection transistor connected between the output terminal of the control module and the third node, and a control terminal of the first protection transistor receives the first voltage signal;
and/or,
the shift register unit comprises a second protection transistor connected between the second node and a control terminal of the output module, and a control terminal of the second protection transistor receives the first voltage signal.

7. The display panel according to claim 3, wherein the output module comprises a first output transistor and a second output transistor; and
a control terminal of the first output transistor is the second control terminal, a first terminal of the first output transistor receives the second clock signal, and a second terminal of the first output transistor is connected to an output terminal of the output module; a control terminal of the second output transistor is connected to the second node, a first terminal of the second output transistor receives a third voltage signal, and a second terminal of the second output transistor is connected to the output terminal of the output module.

8. The display panel according to claim 7, wherein a voltage value of the first voltage signal is VGL1, and a voltage value of the third voltage signal is VGL2, wherein VGL1≤VGL2.

9. The display panel according to claim 1, wherein
the output module comprises a first output transistor and a second output transistor; a control terminal of the first output transistor is the second control terminal, a first terminal of the first output transistor receives the second clock signal, and a second terminal of the first output transistor is connected to an output terminal of the output module; and a control terminal of the second output transistor is connected to the second node, a first terminal of the second output transistor receives the third voltage signal, and a second terminal of the second output transistor is connected to the output terminal of the output module; and
the shift register unit comprises a coupling module, a control terminal of the coupling module and the control terminal of the second output transistor are connected to a fourth node, and the coupling module is configured to pull down a potential of the fourth node via coupling at least during a period in which the fourth node is at a low potential.

10. The display panel according to claim 9, wherein an operation period of the shift register unit comprises a third period and a fourth period; during the third period and the fourth period, the fourth node is at a low potential;
during the third period, the coupling module writes a high-level signal of the first clock signal to a fifth node in the coupling module under control of the fourth node; and
during the fourth period, the coupling module writes a low-level signal of the first clock signal to the fifth node under control of the fourth node, and pulls down the potential of the fourth node based on a change in a potential of the fifth node.

11. The display panel according to claim 10, wherein the operation period of the shift register unit comprises a first period; and during the first period, the first node is at a low potential and the fourth node is at a high potential; and
during the first period, the coupling module writes a high potential of a second voltage signal to the fifth node under control of the first node.

12. The display panel according to claim 9, wherein the coupling module comprises a fourth transistor, a fifth transistor, and a first capacitor; and
a control terminal of the fourth transistor and the control terminal of the second output transistor are respectively connected to the fourth node, a control terminal of the fifth transistor is connected to the first node, a first terminal of the fourth transistor receives the first clock signal; a second terminal of the fourth transistor, a second terminal of the fifth transistor and a plate of the first capacitor are connected to a fifth node; a first terminal of the fifth transistor receives a second voltage signal; and the other plate of the first capacitor is connected to the control terminal of the fourth transistor.

13. The display panel according to claim 12, wherein
an operation period of the shift register unit comprises a first period, a third period, and a fourth period; during the third period and the fourth period, the fourth node is at a low potential; and during the first period, the first node is at a low potential, and the fourth node is at a high potential;
during the first period, the fifth transistor writes a high potential of the second voltage signal to the fifth node under control of the first node;
during the third period, the fourth transistor writes a high-level signal of the first clock signal to the fifth node under control of the fourth node; and
during the fourth period, the fourth transistor writes a low-level signal of the first clock signal to the fifth node under control of the fourth node, and pulls down the potential of the fourth node based on a change in a potential of the fifth node.

14. The display panel according to claim 12, wherein the coupling module further comprises a sixth transistor and an input sub-module;
the control terminal of the fourth transistor is connected to the fourth node through the sixth transistor, a control terminal of the sixth transistor is connected to the control terminal of the fourth transistor, a first terminal of the sixth transistor and the control terminal of the sixth transistor are connected to a sixth node, and a second terminal of the sixth transistor is connected to the fourth node; and
an output terminal of the input sub-module is connected to the sixth node, and the input sub-module is configured to write a voltage to the sixth node based on a first voltage signal, a third clock signal, and a potential of the first node.

15. The display panel according to claim 14, wherein an operation period of the shift register unit comprises a first period, a third period, and a fourth period; during the third period and the fourth period, the fourth node is at a low potential; and during the first period, the first node is at a low potential and the fourth node is at a high potential;
during the first period, the fifth transistor writes a high potential of the second voltage signal to the fifth node under control of the first node, and the input sub-module is turned on and writes a high potential to the sixth node under control of the first node;
during the third period, the input sub-module is turned on and writes a low level of the first voltage signal to the sixth node under control of a low level of the third clock signal, the fourth transistor writes the high-level signal of the first clock signal to the fifth node under control of the sixth node, and the sixth transistor conducts a path between the fourth node and the sixth node under control of the sixth node; and
during the fourth period, the input sub-module is turned off under control of a high level of the third clock signal, the fourth transistor writes the low-level signal of the first clock signal to the fifth node under control of the sixth node, and pulls down a potential of the sixth node based on a change in a potential of the fifth node, and the sixth transistor conducts the path between the fourth node and the sixth node under control of the sixth node, and pulls down the potential of the fourth node.

16. The display panel according to claim 14, wherein the input sub-module comprises a seventh transistor, an eighth transistor, and a ninth transistor;
a control terminal of the seventh transistor receives the third clock signal, a first terminal of the seventh transistor receives the first voltage signal, a second terminal of the seventh transistor is connected to a first terminal of the eighth transistor, a control terminal of the eighth transistor receives the first voltage signal, and a second terminal of the eighth transistor is connected to the sixth node; and
a control terminal of the ninth transistor is connected to the first node, a first terminal of the ninth transistor receives the third clock signal, and a second terminal of the ninth transistor is connected to the second terminal of the seventh transistor.

17. The display panel according to claim 12, wherein
the shift register unit comprises a third protection transistor, a control terminal of the third protection transistor receives a first voltage signal, a first terminal of the third protection transistor is connected to an output terminal of the input module, and a second terminal of the third protection transistor is connected to the first node.

18. The display panel according to claim 3, wherein
the stage transmission module comprises a third output transistor and a fourth output transistor; and
a control terminal of the third output transistor is the first control terminal, a first terminal of the third output transistor receives the first clock signal, and a second terminal of the third output transistor is connected to an output terminal of the stage transmission module; a control terminal of the fourth output transistor is connected to the second node, a first terminal of the fourth output transistor receives the second voltage signal, and a second terminal of the fourth output transistor is connected to the output terminal of the stage transmission module.

19. The display panel according to claim 3, wherein the input module comprises a first sub-module, a second sub-module, and a third sub-module;
the first sub-module is configured to write a voltage to the first node based on an input signal and a third clock signal;
the second sub-module is configured to write a voltage to the second node based on the third clock signal, an output signal of the first sub-module, and the first voltage signal; and
the third sub-module is configured to write a high level to the first node based on an output signal of the second sub-module, the first clock signal, and the second voltage signal.

20. The display panel according to claim 19, wherein
the first sub-module comprises a tenth transistor, a control terminal of the tenth transistor receives the third clock signal, a first terminal of the tenth transistor receives the input signal, and a second terminal of the tenth transistor is connected to the first node;
the second sub-module comprises an eleventh transistor and a twelfth transistor, a control terminal of the eleventh transistor receives the third clock signal, a first terminal of the eleventh transistor receives the first voltage signal, a second terminal of the eleventh transistor is connected to the second node, a control terminal of the twelfth transistor is connected to the second terminal of the tenth transistor, a first terminal of the twelfth transistor receives the third clock signal, and a second terminal of the twelfth transistor is connected to the second node; and
the third sub-module comprises a thirteenth transistor and a fourteenth transistor, a control terminal of the thirteenth transistor is connected to the second node, a first terminal of the thirteenth transistor receives the second voltage signal, a second terminal of the thirteenth transistor is connected to a first terminal of the fourteenth transistor, a control terminal of the fourteenth transistor receives the first clock signal, and a second terminal of the fourteenth transistor is connected to the first node.

21. The display panel according to claim 20, wherein an operation period of the shift register unit comprises a first period, a second period, a third period, and a fifth period;
during the fifth period, the tenth transistor writes a low level of the input signal to the first node under control of a low level of the third clock signal, the eleventh transistor writes a low level of the first voltage signal to the second node under control of the low level of the third clock signal, and the twelfth transistor writes the low level of the third clock signal to the second node under control of the first node;
during the first period, the tenth transistor and the eleventh transistor are turned off under control of a high level of the third clock signal, the first node is at a low potential, and the twelfth transistor writes the high level of the third clock signal to the second node under control of the first node;
during the third period, the tenth transistor writes a high level of the input signal to the first node under control of the low level of the third clock signal, the eleventh transistor writes the low level of the first voltage signal to the second node under control of the low level of the third clock signal, the thirteenth transistor is turned on under control of the second node, and the fourteenth transistor is turned off under control of a high level of the first clock signal; and
during the second period, the tenth transistor and the eleventh transistor are turned off under control of the high level of the third clock signal, the first node is at a high potential, the second node is at a low potential, the thirteenth transistor is turned on under control of the second node, and the fourteenth transistor is turned on and writes a high level of the second voltage signal to the first node under control of a low level of the first clock signal.

22. The display panel according to claim 1, further comprising a scan line and a plurality of pixel circuits,
wherein at least one of the plurality of pixel circuits comprises a first functional transistor, and the first functional transistor is an n-type transistor, the plurality of pixel circuits are arranged in a pixel circuit row along a first direction, the scan line extends along the first direction, and the scan line is connected to control terminals of a plurality of first functional transistors in the pixel circuit row; and
wherein the shift register unit comprises a first shift register unit and a second shift register unit, the first shift register unit and the second shift register unit are arranged at both sides of the scan line in the first direction, an output terminal of the first shift register unit is connected to one end of the scan line, and an output terminal of the second shift register unit is connected to another end of the scan line.

23. A display apparatus, comprising the display panel according to any one of claims 1 to 22.
